Europäisches Patentamt

European Patent Office

Office européen des brevets

(11) Publication number: **0 167 242**
A2

# (12) EUROPEAN PATENT APPLICATION

(21) Application number: **85303225.8**

(22) Date of filing: **07.05.85**

(51) Int. Cl.⁴: **H 03 K 19/092**
**H 03 K 5/02**

(30) Priority: **07.05.84 US 607671**

(43) Date of publication of application:
**08.01.86 Bulletin 86/2**

(84) Designated Contracting States:
**DE FR GB IT**

(71) Applicant: **VERSATILE INTEGRATED MODULES INC**
**470 B Lakeside Drive**
**Sunnyvale California 94086(US)**

(72) Inventor: **van der Gaag, Leonard C.**
**1452 Oak Canyon Court**
**San Jose CA 95120(US)**

(74) Representative: **Barnard, Eric Edward et al,**
**BROOKES & MARTIN High Holborn House 52/54 High**
**Holborn**
**London WC1V 6SE(GB)**

(54) Triple-state circuit.

(57) A triple-state circuit comprising a logical high and a logical low signal circuit, an input over-ride and biasing circuit, a data input line and a data output line. The selective application of logical high data signals, logical low data signals and a high impedance to the data input line produces corresponding logical high data signals, logical low data signals and a high output impedance on the data output line. The input over-ride and biasing circuit in response to a control signal provides for a high output impedance on the data output line independent of the status of the signals on the data input line. When the above circuits are providing a high impedance on the data output line, the circuits also permit the coupling of signals to the date output line having amplitudes which exceed the magnitude of reference potentials used for providing the logical high and low data output signals on the data output line.

EP 0 167 242 A2

TRIPLE-STATE CIRCUIT

FIELD OF THE INVENTION

The present invention relates to triple-state circuits in general and in particular to a triple-state programmable signal amplitude buffer circuit with override control.

BACKGROUND OF THE INVENTION

A conventional triple-state circuit comprises an input data line, an data output line and a control line. In operation, a logical high and a logical low on the input data line and a suitable control signal on the control line will produce a logical high, a logical low and a high output impedance on the data output line, respectively. In the context of a triple-state circuit, a high input or output impedance is considered to be, ideally, an infinite impedance or at least, an impedance of sufficient magnitude to result in negligible current drain from circuits coupled to the high impedance lines.

As solid state circuit designs have evolved, certain types of circuits have become standard in the industry, such as for example, TTL and ECL circuits. TTL circuits are characterized in that they respond to and output signals comprising a logical high of 5 volts and a logical low of 0 volts. ECL circuits are characterized in that they respond to and output signals comprising a logical high of -0.8 volts and a logical low of -1.6 volts. Other circuits which have or are becoming standards in the industry respond to and output logical high and low signals having different magnitudes.

A number of disadvantages are encountered in using conventional triple-state circuits as described above. One disadvantage is that no provision is made in conventional triple-state circuits for providing a high output impedance on the output data line in response to a high input impedance or open circuit in series with the input data line. In all cases, a control signal must be applied to the control line in order to provide a high output impedance on the data output line.

Another disadvantage is that a conventional triple-state circuit which is designed to respond to a specific type of signal, such as a TTL or an ECL signal, will only provide the same type of signal on its data output line. There is usually no provision for changing the magnitude of the logical high and low data output signals independently of the magnitude of the logical high and low data input signals.

Still another disadvantage of the conventional triple-state circuits is that none provide a means for using the circuits alone or with other types of circuits to couple TTL, ECL, other digital signals, as well as analog signals, each having different high and low peak amplitudes, to the same data signal bus. In all cases, conventional triple-state circuits restrict the type of signal which can be coupled to a given data bus to a specific type of signal, e.g. TTL, ECL, or the like.

## SUMMARY OF THE INVENTION

In view of the foregoing, a principle object of the present invention is a novel triple-state circuit which comprises features for eliminating certain of the disadvantages of prior known triple-state circuits described above.

Among the features of a circuit according to the present invention, there is provided a means responsive to a logical high data signal, a logical low data signal and a high input impedance on an data input line for providing logical high and logical low data signals and a high output impedance on an data output line, respectively.

Another feature of a circuit according to the present invention is a means for changing the magnitude of logical high and low data signals provided on an data output line independently of the magnitude of logical high and low data signals applied to the data input line.

Another feature of a circuit according to the present invention is a means which permits a plurality of data signals from different signal sources to be coupled to a single data bus even though the positive and negative peak amplitudes of the signals may be different or exceed the reference voltages used in the triple-state circuits coupled to the data bus.

Another feature of a circuit according to the present invention is a means for providing a high output impedance on the data output line of the circuit independently of the magnitude of the input data signals applied or the output impedance of the ouput of a circuit coupled to the data input line thereof.

Still another feature of the present invention is that all transistors in the circuit are operated in a nonsaturated mode. Because all of the transistors in the circuit are operated in a nonsaturated mode, fast transient times and short propagation delays can be achieved.


## BRIEF DESCRIPTION OF THE DRAWING

The above and other objects, features and advantages of the present invention will become apparent from the following detailed description of the accompanying drawing in which:

Fig. 1 is a diagram of a data bus circuit incorporating a pair of triple-state circuits according to the present invention.

Figs. 2A and 2B are schematic diagrams of a triple-state circuit according to the present invention.

DETAILED DESCRIPTION OF THE DRAWING

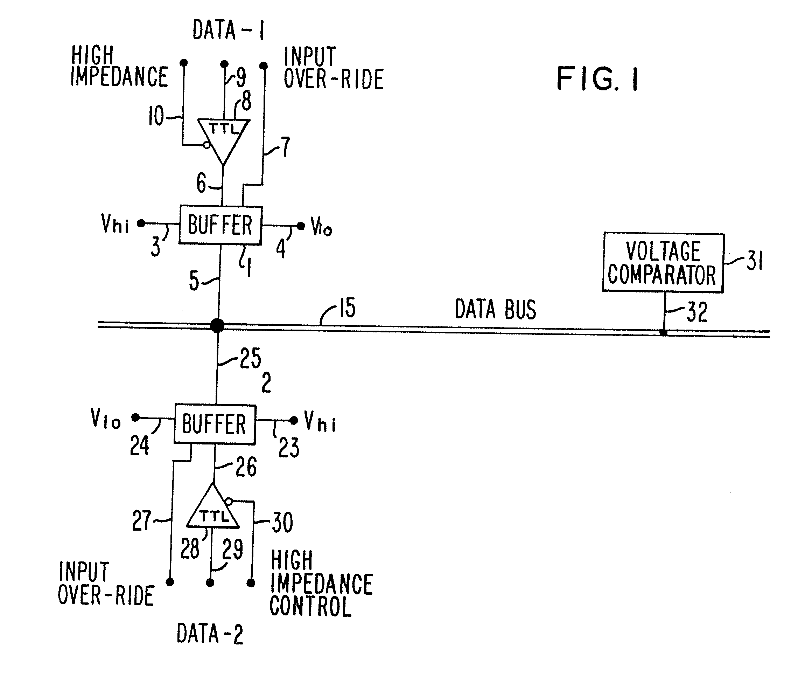

Referring to Fig. 1, there is provided in accordance with the present invention, a pair of triple-state buffer circuits 1,2. Circuit 1 is provided with a high reference voltage line 3, a low reference voltage line 4, a data output line 5, a data input line 6 and an input over-ride control line 7. The data output line 5 of the circuit 1 is coupled to a data bus 15. The data bus 15 may comprise a single data line or one of a plurality of data lines to which a plurality of signal sources or receivers is coupled.

Coupled to the input line 6 of the circuit 1, there is provided the output of a conventional TTL triple-state circuit 8. Circuit 8 is provided with a data input line 9 and a high output impedance control line 10.

The circuit 2 is provided with a high reference voltage line 23, a low reference voltage line 24, a data output line 25, a data input line 26 and an input over-ride control line 27. The output line 25 of the circuit 2 is coupled in parallel with the line 5 to the data bus 15.

Coupled to the input line 26, there is provided the output of a conventional TTL triple-state circuit 28. Circuit 28 is provided with a data input line 29 and a high output impedance control line 30.

In addition to the above described circuits, there is also provided coupled to the bus 15 a voltage comparator circuit 31. Circuit 31 is coupled to the bus 15 by means of a line 32. The circuit 31 is shown coupled to the bus 15 for the purpose of illustrating the wide utility of the present invention as will be described in detail below.

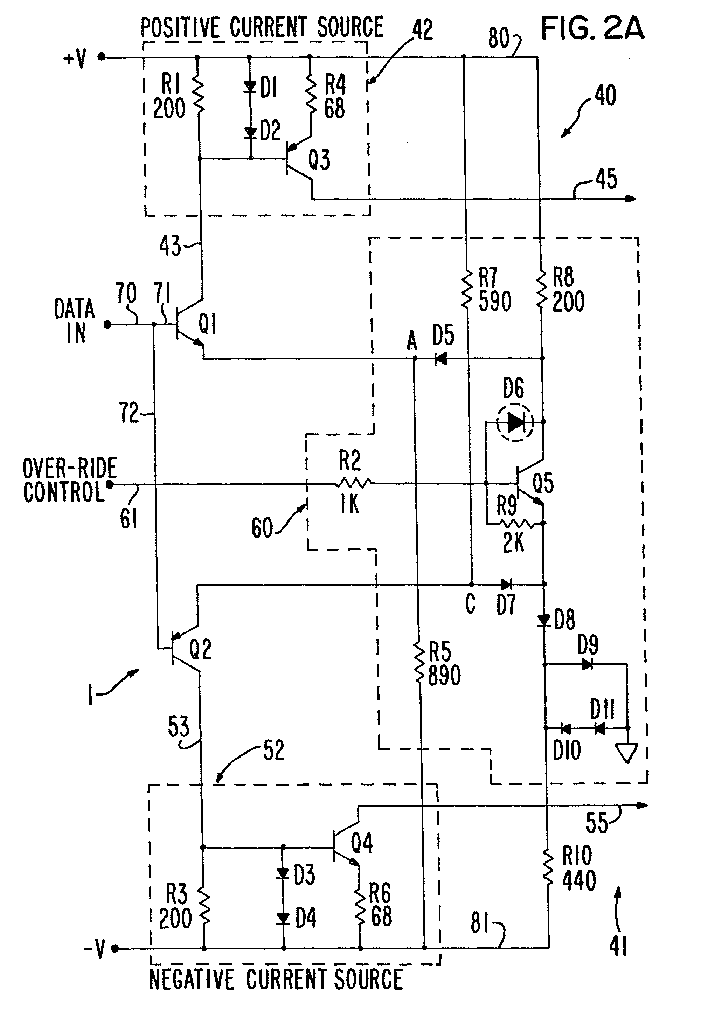

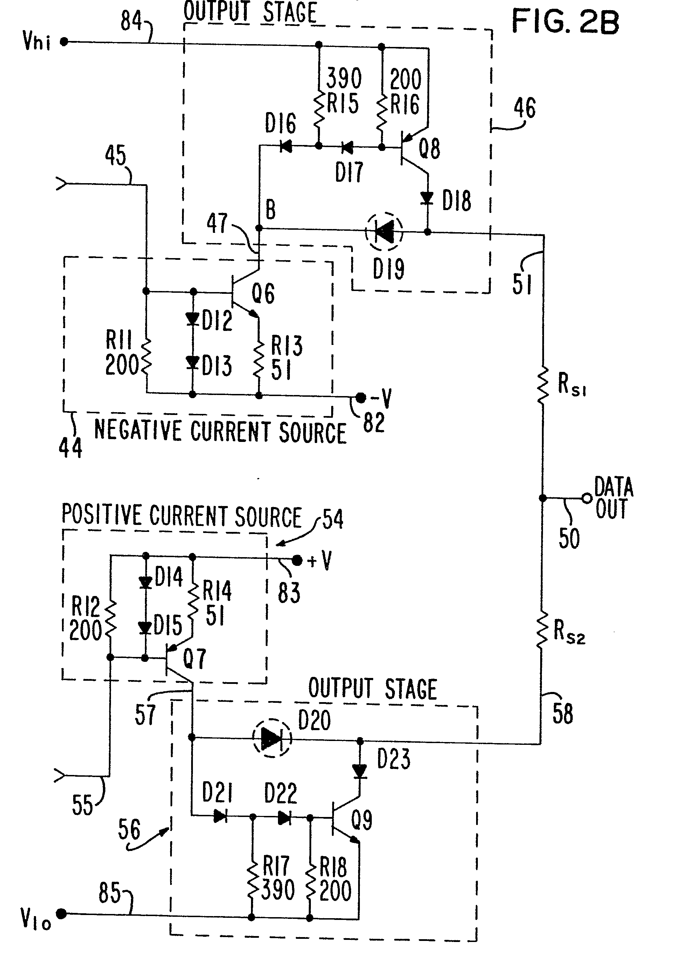

Referring to Figs. 2A and 2B, circuits 1,2, except as hereinafter described, are substantially identical.

5

Accordingly, only circuit 1 will be described in detail.

In circuit 1, there is provided a high signal leg designated generally as 40 and a low signal leg designated generally as 41. In the leg 40, there is provided an input NPN transistor Q1. The collector of Q1 is coupled to a positive constant current source designated generally as 42 by means of a line 43. The output of current source 42 is coupled to the input of a negative constant current source designated generally as 44 by means of a line 45. The output of the current source 44 is coupled to an output stage designated generally as 46 by means of a line 47. The output of the output stage 46 is coupled to an data output line 50 by means of a series resistor $R_{S1}$ and a line 51.

In the leg 41, there is provided an input PNP transistor Q2. The collector of Q2 is coupled to a negative constant current source designated generally as 52 by means of a line 53. The output of the current source 52 is coupled to the input of a positive constant current source designated generally as 54 by means of a line 55. The output of the current source 54 is coupled to an output stage designated generally as 56 by means of a line 57. The output of the output stage 56 is coupled to the data output line 50 by means of a series resistor $R_{S2}$ and a line 58.

To bias the transistors Q1 and Q2 and provide an input over-ride control function in the circuit 1, there is provided an input over-ride control/biasing circuit designated generally as 60 having an over-ride control signal line 61.

Input data is received by the circuit 1 by means of an data input line 70 which is coupled to the bases of Q1 and Q2 by means of a pair of lines 71,72, respectively.

In the positive current source 42, there is provided a 200 ohm resistor R1, coupled in parallel with a pair of series connected diodes D1,D2. The cathode of D2 and one end of the resistor R1 is coupled to the line 43 and the base of an PNP transistor Q3. The emitter of Q3 is coupled to a source of positive potential, e.g. +8 volts, through a 68 ohm resistor R4, the anode of diode D1 and the other end of the resistor R1 by means of a line 80. The collector of Q3 is coupled to the line 45.

In the negative current source 52, there is provided a 200 ohm resistor R3 which is coupled in parallel with a pair of series connected diodes D3,D4. The anode of D3 and one end of the resistor R3 is coupled to the line 53 and the base of a NPN transistor Q4. The emitter of Q4 is coupled to a source of negative potential, e.g. -8 volts, through a 68 ohm resistor R6, the cathode of diode D4 and the other end of the resistor R3 by means of a line 81.

In negative current source 44, there is provided a 200 ohm resistor R11 coupled in parallel with a pair of series connected diodes D12,D13 to the line 45 and the base of a NPN transistor Q6. The emitter of Q6 is coupled through a 51 ohm resistor R13 to the cathode of the diode D13, the other end of the resistor R11 and a source of negative potential, e.g. -8 volts, by means of a line 82. The collector of Q6 is coupled to the line 47.

In the positive current source 54, there is provided a 200 ohm resistor R12 coupled in parallel with a pair of series connected diodes D14,D15 to the line 55 and the base of a PNP transistor Q7. The emitter of Q7 is coupled through a 51 ohm resistor R14 to the anode of the diode D14, the other end of the resistor R12 and a source of positive potential, e.g. +8 volts, by means of a line 83. The collector of Q7 is coupled to the line 57.

As will be noted, the components of positive current sources 42 and 54 and the negative current sources 44 and 52 are identical with the exception of the types of transistors used and the magnitude of the resistor in the emitter circuit of each of the transistors therein.

In the output stage 46 of the high signal leg 40, there is provided a plurality of diodes D16,D17,D18 and a hot carrier diode D19, a 390 ohm resistor R15, a 200 ohm resistor R16 and a PNP transistor Q8. The cathodes of the diodes D16 and D19 are coupled to the line 47. The anode of the diode D16 is coupled to the cathode of the diode D17 and through the resistor R15 to a source of a high reference voltage, e.g. +10 volts, by means of a line 84. The anode of the diode D17 is coupled to the base of Q8 and through the resistor R16 to the line 84 and the emitter of Q8. The collector of Q8 is coupled through the diode D18 to the line 51 and through the diode D19 to the line 47.

In the output stage 56 in the low signal leg 41, there is provided a hot carrier diode D20 and a plurality of diodes D21,D22,and D23, a 390 ohm resistor R17, a 200 ohm resistor R18 and a NPN transistor Q9. The anodes of the diodes D20,21 are coupled to the line 57. The cathode of diode D21 is coupled to the anode of diode D22 and through the resistor R17 to a source of low reference voltage, e.g. -10 volts, by means of a line 85. The cathode of diode D22 is coupled to the base of Q9 and through the resistor R18 to the line 85 and the emitter of Q9. The cathode of the diode D20 is coupled to the line 58 and through the diode D23 to the collector of Q9.

In the bias and input over-ride control circuit 60, there is provided an over-ride control line 61 coupled to a 1K ohm resistor R2. Resistor R2 is coupled to the base of an NPN transistor Q5, through a 2K ohm resistor R9 to the emitter of Q5 and through a hot carrier diode D6 to the collector of Q5. The collector of Q5 is also coupled through a 200 ohm resistor R8 to the +8 volt supply by means of the line 80 and through a diode D5 to the emitter of Q1. The anode of diode D5 is coupled to the collector of Q5 and the cathode of diode D5 is coupled through an 890 ohm resistor R5 to the -8 volt supply by means of the line 81. The emitter of Q5 is coupled to the anode of a diode D8 and through a diode D7 to the emitter of transistor Q2. The emitter of Q2 is also coupled through a 590 ohm resistor R7 to the +8 volt supply by means of the line 80. The cathode of the diode D8 is coupled to ground through a diode D9 which is coupled in parallel with a pair of series connected diodes D10 and D11 and through a 440 ohm resistor R10 to the -8 volt supply by means of the line 81.

In the following description of the operation of circuit 1, it is assumed that each of the diodes in circuit 1, except diode D6, has a forward voltage drop of .5 volts, that all of the transistors in circuit 1 are operated in a nonsaturated mode and that the forward emitter-to-base (PNP) and base-to-emitter (NPN) voltage drops are .5 volts. Diode D6 (a hot carrier diode), which acts as a Baker clamp, is assumed to have a forward voltage drop of .4 volts. Because all of the transitors in the circuit are operated in a nonsaturated mode, fast transient times and short propagation delays can be obtained.

Thus, in operation, with a +5 volt signal applied to the over-ride control line 61, transistor Q5 is conducting, i.e. is on. With Q5 on, the potential on a node A between the emitter of Q1 and the cathode of diode D5 is +0.6 volts. With +0.6 volts on the emitter of Q1, a +5 volt TTL signal, i.e. a logical high signal, on the data input line 70 coupled to the base of Q1 will cause Q1 to turn on. When Q1 turns on, a positive constant current of approximately 8 milliamps is caused to flow on the line 45 from the positive constant current source 42 to the negative current source 44 turning on transistor Q6. When Q6 is turned on and with the high reference voltage on line 84 having a magnitude of +10 volts, a potential of +8.5 volts is caused to appear on a node B between the cathode of diode D19 and the collector of Q6. With a potential of +8.5 volts on node

0167242

B, the diode drop of D19 causes the potential on the line 51 to be +9 volts. It should be noted that the potential on line 51 will always be equal to the high reference voltage minus 1 volt when it reaches its quiescent state due to the diode drops in the output stage 46. Consequently, to change the magnitude of the signal on the output line 50, all that is required is to change the magnitude of the positive or high reference voltage applied to the line 84.

Referring to the operation of the low signal leg of the circuit 1, with Q5 turned on, a bias potential of +1.5 volts appears on a node C between the anode of the diode D7 and the emitter of Q2. Under these conditions, when the TTL signal on the input line 70 goes from a logical high of +5 volts to a logical low of 0 volts, Q1 turns off and Q2 turns on. When Q2 turns on, a negative constant current of approximately 8 milliamps is caused to flow in the line 55 turning on Q7 in the positive constant current source 54. When Q7 turns on, Q9 in the output stage 56 is turned on causing a -9 volt potential to appear on the line 58.

It will be noted that while the potential on line 51 due to the turning on of the transistor Q8 in the output stage 46 is always 1 volt less than the high reference potential when it reaches its quiescent state, the potential on line 58 due to the turning on of the transistor Q9 in the output stage 56 is always 1 volt more than the low reference potential when it reaches its quiescent state. Also, as described above with respect to the output stage 46, to change the magnitude of the potential on the line 58, all that is required is to change the magnitude of the low reference voltage applied to the line 85. Consequently, if a TTL output signal is desired on the lines 51 and 58, the high reference potential applied to line 84 should be +6 volts and the low reference potential applied to line 85 should be -1 volts for a +5 and 0 volt output signal, respectively. If an ECL output signal is desired on the lines 51 and 58, the high reference potential applied to line 84 should be -1.8 volts and the low reference potential applied to line 85 should be -2.6 volts for a -.6 and a -1.8 volt output signal, respectively. Of course, the magnitudes of the high and low reference potentials may be any desired magnitude suitable for a particular application.

When the source of the data signals applied to the data input line 70 is a triple-state circuit or other circuit which can be operated so as to provide a high output impedance to the line 70, both input transistors Q1 and Q2 will be turned off causing both of the transistors Q8 and Q9 in the output stages 46 and 56 to be turned off. When both Q8 and Q9 are turned off, the output impedance on the data output line 50 is high.

Under certain circumstances, it is desirable to cause the circuit 1 to have a high output impedance on the line 50 regardless of the data signals applied to or the magnitude of the impedance on the data input line 70. Under such circumstances, a signal, e.g. 0 volts, is applied to the over-ride control line 61 to turn off transistor Q5. When transistor Q5 is turned off, the potential on node A is equal to or greater than +5 volts, as determined by the magnitudes of the resistors R8 and R5, and the potential on node C is 0 volts, as determined by the diodes D7,D8,D10 and D11 and resistor R10. With the aforementioned potentials on nodes A and C, both transistors Q1 and Q2 will be held off. They will be held off because the conventional logical high of a TTL input signal does not exceed +5 volts and the logical low of a TTL input signal does not go below 0 volts. Consequently, the circuit 1 can be caused to have a high output impedance on the data output line 50, regardless of the signal applied to the data input line 70.

Another important feature of the present invention is the fact that when the output impedance of the circuit 1 is high, potentials can be applied to the data output line 50 which are greater than and less than the high and low reference potentials applied to the lines 84 and 85, respectively. Indeed, the only limitation on the magnitudes of the potentials which can be applied to the data output line 50 when the circuit 1 is providing a high output impedance is the breakdown voltage of the transistors Q6,Q7,Q8 and Q9 and the diodes D16,D18,D19,D20,D21 and D23. The element in the circuit 1 which provides this feature is the diode D18 in the output stage 46 and the diode 23 in the output stage 56.

Thus, in operation, it can be seen that if a potential exceeding +10 volts is applied to the line 51, the diodes D18 and D16 will be reverse biased. Similarly, if a potential of less than -10 volts is applied to the line 58, the diodes D23 and D21 will be reversed biased.

While a preferred embodiment of the present invention is described above and several alternative arrangements, reference potentials, and the like, have been suggested, it is contemplated that still other modifications may be made thereto without departing from the spirit and scope of the present invention. Accordingly, it is intended that the scope of the invention not be limited to the embodiments described, but, rather, that it be determined by reference to the claims hereinafter provided.

CLAIMS

1. A triple-state circuit comprising:

a data input line;

a data output line; and

means responsive to the selective application of a logical high data signal, a logical low data signal, and a high impedance to said data input line for providing a corresponding logical high data signal, a logical low data signal and a high output impedance on said output line.

2. A circuit according to claim 1 comprising:

means responsive to a control signal for providing a high output impedance on said data output line independently of said selective application of said logical high data signal, said logical low signal and said high impedance to said data input line.

3. A triple-state circuit comprising:

a data input line;

a data output line;

means responsive to the selective application of a logical high and a logical low data signal to said data input line for providing a corresponding logical high and logical low data signal on said data output line; and

means which permits changing the magnitude of each of said logical high and low data signals on said data output line independently of each other and independently of the magnitude of said logical high and logical low data signals applied to said data input line.

4. A circuit according to claim 1 comprising:

means responsive to a high reference voltage and a low reference voltage for providing said logical high and logical low data signals on said data ouput line; and

means which permits the application of a voltage to said data output line when said responsive means provides said high output impedance on said data output line which can exceed the magnitude of said high and low reference voltages.

5. A circuit according to claim 2 comprising:

means responsive to a high reference voltage and a low reference voltage for providing said logical high and logical low data signals on said data ouput line; and

means which permits the application of a voltage to said data output line when said responsive means provides said high output impedance on said data output line which can exceed the magnitude of said high and low reference voltages.

6. A circuit according to claim 1 wherein said means for providing said logical high and logical low signals on said data output line comprises a first and a second means, wherein each of said first and second means comprises:

a positive constant current source;

a negative constant current source;

an output stage, said output stage comprising a transistor which is coupled to said data ouput line and operated in a nonsaturated mode; and

an input transistor coupled to said data input line for turning on and turning off said current sources and said output stage.

7. A circuit according to claim 6 wherein each of said current sources comprises:

a transistor having a base and an emitter;

a resistor for coupling said emitter to a source of potential;

a pair of diodes coupled in series for coupling said base to said source of potential;

a resistor coupled in parallel with said diodes; and

means for coupling one of said current sources to said input transistor and to the other of said current sources; and

wherein said output stage transistor comprises an emitter, a base and a collector;

means for coupling the emitter of said transistor in said ouput stage to a source of reference potential;

a first resistor for coupling said base of said transistor in said output stage to said source of reference potential;

a first diode coupled to said base of said transistor in said output stage and through a second resistor to said source of reference potential;

a second diode coupled to said first diode and said second resistor;

means for coupling said second diode to the output of one of said current sources;

a third diode coupled to said second diode and said data output line; and

a fourth diode for coupling said collector of said transistor in said output stage to said data output line.

FIG. I

FIG. 2A

FIG. 2B

OUTPUT STAGE

NEGATIVE CURRENT SOURCE

POSITIVE CURRENT SOURCE

OUTPUT STAGE

DATA OUT